(19) **Europäisches Patentamt**

**European Patent Office**

**Office européen des brevets**

(11) **EP 0 534 872 B1**

(12) **FASCICULE DE BREVET EUROPEEN**

(45) Date de publication et mention
de la délivrance du brevet:
**03.06.1998 Bulletin 1998/23**

(51) Int Cl.6: **H01L 27/08**, H01L 21/3205,
H01L 21/329

(21) Numéro de dépôt: **92420323.5**

(22) Date de dépôt: **22.09.1992**

(54) **Résistance de précision et procédé de fabrication**

Präzisionswiderstand und Verfahren zur Herstellung

Precision resistor and method of manufacturing

(84) Etats contractants désignés:
**DE FR GB IT**

(30) Priorité: **26.09.1991 FR 9112143**

(43) Date de publication de la demande:
**31.03.1993 Bulletin 1993/13**

(73) Titulaire: **SGS-THOMSON MICROELECTRONICS S.A.**
**94250 Gentilly (FR)**

(72) Inventeur: **Jimenez, Jean**
**F-38500 Voiron (FR)**

(74) Mandataire: **de Beaumont, Michel**
**1bis, rue Champollion**
**38000 Grenoble (FR)**

(56) Documents cités:
- **PATENT ABSTRACTS OF JAPAN vol. 14, no. 108 (E-896)(4051) 27 Février 1990 JP-A-13 09 365**
- **PATENT ABSTRACTS OF JAPAN vol. 11, no. 20 (E-472)(2467) 20 Janvier 1987 & JP-A-61 191 061**
- **PATENT ABSTRACTS OF JAPAN vol. 11, no. 108 (E-495)(2555) 4 Avril 1987 &JP-A-61 256 756**
- **IBM TECHNICAL DISCLOSURE BULLETIN. vol. 24, no. 7A, Décembre 1991, NEW YORK US pages 3405 - 3406 N.G. ANANTHA 'Composite temperature-compensated resistor'**
- **PATENT ABSTRACTS OF JAPAN vol. 11, no. 20 (E-472)(2467) 20 Janvier 1987 & JP-A-61 191 060**
- **PATENT ABSTRACTS OF JAPAN vol. 9, no. 53 (E-301)(1776) 7 Mars 1985 &JP-A-59 191 368**

**Description**

La présente invention concerne le domaine des circuits intégrés et plus particulièrement la fabrication d'une résistance dans un circuit intégré.

Classiquement, une résistance dans un circuit intégré est formée en délimitant dans un substrat semiconducteur ou dans une couche de silicium polycristallin ou de métal formée au-dessus de ce substrat une bande dont les deux extrémités sont munies de métallisation. La valeur de la résistance dépend donc de la forme de la bande et de la résistivité de son matériau constituant.

Un avantage bien connu des circuits intégrés est que deux résistances identiques formées sur un même circuit intégré auront la même valeur et que deux résistances présentant un rapport de forme déterminé présenteront un rapport de valeurs déterminé avec précision. Toutefois, un inconvénient est que la valeur absolue de la résistance n'est pas déterminée avec précision. En effet, d'un lot de fabrication au suivant, les conditions peuvent varier, et notamment les conditions d'attaque de résine qui déterminent, à la suite d'un masquage, les dimensions effectives en largeur et longueur d'une zone élémentaire. Ainsi, des résistances formées à partir d'un même masque dans des lots de fabrication différents peuvent présenter des variations de valeur de l'ordre de quelques pourcents, cette variation pouvant aller jusqu'à environ 20 %. Ainsi, dans le domaine des circuits intégrés, lors de la conception d'un circuit, on s'efforce de déterminer les valeurs de fonctionnement par des rapports de résistances, ou des rapports de surface de transistors. Il existe toutefois des cas où il serait utile de disposer de résistances ayant des valeurs absolues bien déterminées. Pour l'instant, l'obtention de telles résistances est pratiquement impossible.

Le document JP-A-59191368 décrit la connexion en série de résistances polycristallines et diffusées pour réduire la surface totale d'une résistance.

Le document JP-A-61191060 décrit la connexion en série de résistances polycristallines et diffusées pour réduire le coefficient de température.

Le document JP-A-1309365 décrit la connexion en parallèle d'une résistance diffusée et d'une résistance en couches minces pour permettre de régler la valeur de la résistance par un ajustage (trimming) après fabrication.

Ainsi, un objet de la présente invention est de prévoir une structure de résistance dans une technologie de fabrication de circuits intégrés, telle que cette résistance ait une valeur déterminée avec précision, indépendamment des fluctuations des paramètres de fabrication.

Pour atteindre cet objet, la présente invention cf. la revendication 1 prévoit une résistance de précision formée sur un substrat semiconducteur comprenant deux bandes d'un matériau conducteur résistif sur isolant ayant chacune une première résistance par carré $R_p$ et une largeur normale $W_p$, définissant entre elles, dans le substrat semiconducteur, une bande de largeur normale $W_m$ dopée en utilisant les bandes de matériau conducteur résistif comme masque et ayant une deuxième résistance par carré $R_m$, deux métallisations reliant respectivement la première et la deuxième extrémité des trois dites bandes. Les largeurs et les résistances par carré sont choisies pour que $R_p W_p = 2R_m W_m$.

Selon un mode de réalisation de la présente invention, le matériau conducteur résistif est du silicium polycristallin dopé.

Selon un mode de réalisation de la présente invention, la résistance est délimitée par des régions d'oxyde épais encadrant une région dans laquelle s'étend la bande dopée, chacune des bandes de matériau conducteur résistif s'étendant partiellement sur une bande d'oxyde épais et partiellement sur une couche d'oxyde mince prolongeant chaque bande d'oxyde épais du côté de l'autre bande d'oxyde épais.

Selon un mode de réalisation de la présente invention, l'ensemble de la bande dopée et des bandes de matériau conducteur résistif est recouvert d'une couche isolante et les métallisations accèdent à leurs extrémités par l'intermédiaire d'ouvertures de contact.

La présente invention prévoit aussi un procédé de fabrication d'une résistance de précision cf. la revendication 5 comprenant les étapes consistant à former des régions d'oxyde épais délimitant entre elles une bande d'un substrat semiconducteur recouverte d'une couche mince d'oxyde ; revêtir la structure d'une couche de silicium polycristallin ; graver dans la couche de silicium polycristallin deux bandes ; graver la couche d'oxyde mince entre les bandes de silicium polycristallin ; doper les bandes de silicium polycristallin et la bande apparente du substrat ; former des contacts aux deux extrémités de l'ensemble des trois bandes.

Ces objets, caractéristiques et avantages ainsi que d'autres de la présente invention seront exposés en détail dans la description suivante de modes de réalisation particuliers faite en relation avec les figures jointes parmi lesquelles :

la figure 1 représente une vue de dessus d'un mode de réalisation d'une résistance de précision selon la présente invention ;

les figures 2A et 2B représentent des vues en coupe selon la ligne I-I de la figure 1.

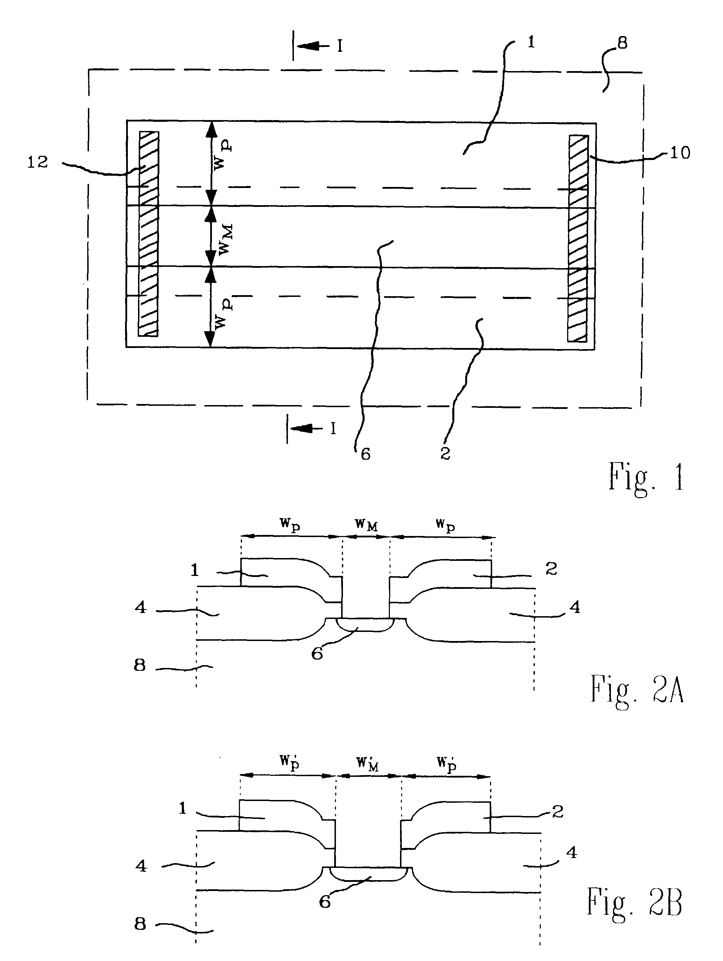

Comme le représentent les figures 1 et 2A, la présente invention prévoit une résistance constituée de deux bandes 1 et 2 d'un matériau conducteur résistif, formées sur un substrat semiconducteur avec interposition d'une couche isolante 4. Entre les bandes 1 et 2, apparaît une portion du substrat qui est dopée en utilisant comme masque les bandes 1 et 2 pour former dans le substrat une bande 6 présentant un niveau de dopage choisi. Bien entendu, le substrat 8 aura un type de dopage opposé à celui de la bande 6 ou sera du même type de dopage mais beaucoup plus faiblement dopé.

Les premières extrémités des bandes 1, 2 et 6 sont interconnectées par une métallisation 10 et les deuxièmes extrémités de ces bandes sont interconnectées par une métallisation 12.

Dans un mode de réalisation particulier de la présente invention, la région où est formée la bande 6 est délimitée par des couches d'oxyde épais prolongées par des couches d'oxyde minces et chacune des bandes conductrices 1 et 2 est formée à cheval sur l'oxyde épais et sur l'oxyde mince afin, de façon classique, de réaliser une isolation entre la bande 6 et d'autres éléments du circuit intégré.

Dans un mode de réalisation particulier de la présente invention, les bandes conductrices 1 et 2 sont en silicium polycristallin dopé lors de la même étape de dopage que la bande 6.

La structure illustrée en figures 1 et 2A peut être fabriquée en utilisant les étapes successives suivantes :

former des zones d'oxyde épais 4 délimitant une bande sur un substrat semiconducteur ;
former sur cette bande une couche d'oxyde mince ;
revêtir le substrat d'une couche de silicium polycristallin ;
graver le silicium polycristallin pour définir des bandes 1 et 2 ;
graver l'oxyde mince pour faire apparaître le substrat entre les bandes 1 et 2 ;
procéder à un dopage par diffusion ou implantation des bandes 1 et 2 et de la bande apparente du substrat pour former la bande 6.

Comme cela est classique dans le domaine des circuits intégrés, on considérera ci-après des valeurs de résistance par carré, c'est-à-dire la valeur de la résistance entre deux métallisations formées sur deux côtés opposés d'une couche de forme carrée. On négligera dans ce qui suit, les effets de bord et de forme bien connus de l'homme de l'art. On appelera $R_p$ la résistance par carré de la couche de silicium polycristallin 1 ou 2, et $R_m$ la résistance par carré de la région dopée 6 formée dans le substrat de silicium monocristallin 8. Alors, la valeur de la résistance par carré du composant illustré en figure 1 sera

$$1/R = 2/R_p + 1/R_m.$$

On va montrer qu'à condition de choisir convenablement les valeurs de $R_p$ et de $R_m$ en relation avec la largeur $W_p$ des bandes 1 et 2 et la largeur $W_m$ de la bande 6, on peut obtenir une résistance ayant une valeur de résistance par carré sensiblement indépendante des fluctuations des paramètres de fabrication.

La figure 2B illustre une résistance, théoriquement formée de la même façon que la résistance de la figure 2A mais dans laquelle les paramètres de gravure ont varié de sorte que les bandes de silicium polycristallin ont été plus gravées que dans le cas précédent, c'est-à-dire qu'elles sont plus étroites. Ainsi, les bandes 1 et 2 auront maintenant des largeurs $W'_p$ telles que $W'_p = W_p - 2dW$. Corrélativement, la bande 6 aura une largeur $W'_m = W_m + 2dW$. Alors, la résistance par carré de la résistance illustrée en figure 1 comprenant en parallèle les bandes 1, 2 et 6 sera :

$$\frac{1}{R'} = \frac{2}{R_p \dfrac{W_p}{W_p - 2dW}} + \frac{1}{R_m \dfrac{W_m}{W_m + 2dW}}$$

c'est-à-dire

$$\frac{1}{R'} = \frac{2W_p - 4dW}{R_p W_p} + \frac{W_m + 2dW}{R_m W_m}$$

$$\frac{1}{R'} = \frac{2}{R_p} + \frac{1}{R_m} - 2dW\left(\frac{2}{R_p W_p} - \frac{1}{R_m W_m}\right)$$

On voit que la valeur de la résistance équivalente R' peut être rendue constante et égale à la valeur R susmentionnée si le facteur multiplicatif de dW est rendu nul, c'est-à-dire si :

$$R_p W_p = 2R_m W_m$$

Cette relation peut facilement être satisfaite pour tout niveau de dopage choisi en choisissant corrélativement l'épaisseur de la couche de silicium polycristallin et/ou le rapport des valeurs $W_m$ et $W_p$.

Bien que la présente invention ait été décrite plus particulièrement dans le cas où les bandes 1 et 2 sont des bandes de silicium polycristallin, on notera qu'elle s'applique également au cas où elles sont constituées de tout autre matériau résistif choisi, par exemple des couches minces d'un métal, d'un métal réfractaire, ou de siliciure métallique.

En outre, on a employé dans la présente description le terme "bande" pour désigner les régions résistives disposées entre les électrodes 10 et 12. L'homme de l'art notera que ces bandes ne sont pas nécessairement rectilignes et que pour des raisons topologiques, on pourra choisir toute forme souhaitée, par exemple en zig-zag, en arrondi, en spirale...

De plus, les bandes 1 et 2 n'ont pas nécessairement la même largeur.

L'ensemble de la structure décrite pourra être revêtu d'une couche isolante avant formation des métallisations 10 et 12, et des contacts pris sur les extrémités des bandes de résistance, ces contacts étant reliés entre eux par des métallisations.

## Revendications

1. Résistance de précision formée sur un substrat semiconducteur (8), comprenant deux bandes d'un matériau conducteur résistif sur isolant (1, 2) ayant chacune une première résistance par carré $R_p$ et une largeur normale $W_p$, définissant entre elles, dans le substrat semiconducteur, une bande (6) de largeur normale $W_m$, dopée en utilisant les bandes de matériau conducteur résistif comme masque et ayant une deuxième résistance par carré $R_m$, deux métallisations (10, 12) reliant respectivement la première et la deuxième extrémité des trois dites bandes, et dans laquelle les largeurs et les résistances par carré sont choisies pour que $R_pW_p = 2R_mW_m$.

2. Résistance selon la revendication 1, caractérisée en ce que ledit matériau conducteur résistif est du silicium polycristallin dopé.

3. Résistance de précision selon la revendication 1, caractérisée en ce qu'elle est délimitée par des régions d'oxyde épais (4) encadrant une région dans laquelle s'étend ladite bande dopée, chacune desdites bandes de matériau conducteur résistif s'étendant partiellement sur une bande d'oxyde épais et partiellement sur une couche d'oxyde mince prolongeant chaque bande d'oxyde épais du côté de l'autre bande d'oxyde épais.

4. Résistance de précision selon la revendication 1, caractérisée en ce que l'ensemble de la bande dopée et des bandes de matériau conducteur résistif est recouvert d'une couche isolante et en ce que lesdites métallisations accèdent à leurs extrémités par l'intermédiaire d'ouvertures de contact.

5. Procédé de fabrication d'une résistance de précision selon l'une quelconque des revendications 1 à 4, caractérisé en ce qu'il comprend les étapes suivantes :

   former des régions d'oxyde épais délimitant entre elles une bande d'un substrat semiconducteur recouverte d'une couche mince d'oxyde ;
   revêtir la structure d'une couche de silicium polycristallin ;
   graver dans la couche de silicium polycristallin deux bandes (1) et (2) dont chacune s'étend le long de ladite bande du substrat semiconducteur et partiellement au-dessus de celle-ci ;
   graver la couche d'oxyde mince entre les bandes de silicium polycristallin ;
   doper les bandes de silicium polycristallin et la bande apparente du substrat ; et
   former un premier contact reliant les premières extrémités des trois bandes et un deuxième contact reliant les deuxièmes extrémités des trois bandes.

## Patentansprüche

1. Präzisionswiderstand, der auf einem Halbleitersubstrat (8) ausgebildet ist, mit zwei Streifen, die aus einem leitenden Widerstandsmaterial (1, 2) auf einem Isolationsmaterial (4) bestehen, die Streifen jeweils einen ersten Widerstandswert pro Quadrat $R_p$ und eine normale Breite $W_p$ hat und zwischen sich in dem Halbleitersubstrat einen Streifen (6) mit einer normalen Breite $W_m$ eingrenzen, der unter Verwendung der Streifen aus dem leitenden Widerstandsmaterial als eine Maske dotiert ist und einen zweiten Widerstandswert pro Quadrat $R_m$ hat, wobei zwei Metallisierungen (10, 12) das erste bzw. das zweite Ende der drei Streifen verbinden und die Breiten und Widerstandswerte pro Quadrat so gewählt sind, daß $R_p \cdot W_p = 2R_m \cdot W_m$.

2. Widerstand nach Anspruch 1, dadurch **gekennzeichnet,** daß das leitende Widerstandsmaterial aus dotiertem polykristallinem Silizium besteht.

3. Präzisionswiderstand nach Anspruch 1, dadurch **gekennzeichnet,** daß er von zwei dicken Oxidbereichen (4) begrenzt ist, die einen Bereich umgeben, in dem sich der dotierte Streifen erstreckt, wobei jeder der aus dem leitenden Widerstandsmaterial bestehenden Streifen sich teilweise über einen dicken Oxidstreifen und teilweise über eine dünne Oxidschicht erstreckt, welche jeden dicken Oxidstreifen in Richtung des anderen dicken Oxidstreifens verlängert.

4. Präzisionswiderstand nach Anspruch 1, dadurch **gekennzeichnet,** daß die Anordnung aus dem dotierten Streifen und den aus dem leitenden Widerstandsmaterial bestehenden Streifen mit einer Isolationsschicht bedeckt ist und die Metallisierungen deren Enden durch Öffnungen kontaktieren.

5. Verfahren zum Herstellen eines Präzisionswiderstands nach einem der Ansprüche 1 bis 4, dadurch **gekennzeichnet,** daß es die folgenden Schritte umfaßt:

   Ausbilden von dicken Oxidbereichen, welche zwischen sich einen Halbleitersubstratstreifen eingrenzen, der mit einer dünnen Oxidschicht bedeckt ist;
   Beschichten der Struktur mit einer polykristallinen Siliziumschicht;
   Ätzen von zwei Streifen (1, 2) in die polykristalline Siliziumschicht, die sich jeweils entlang des Halbleitersubstratstreifens und teilweise darüber erstrecken;
Ätzen der dünnen Oxidschicht zwischen den polykristallinen Siliziumstreifen;
Dotieren der polykristallinen Siliziumstreifen und der freiliegenden Substratstreifen; und
Ausbilden eines ersten Kontakts, der die ersten Enden der drei Streifen verbindet, und eines zweiten Kontakts, der die zweiten Enden der drei Streifen verbindet.

conductor substrate stripe and partially thereover;
etching said thin oxide layer between said polycrystalline silicon stripes;
doping said polycrystalline silicon stripes and the apparent substrate stripe; and
forming a first contact connecting the first extremities of the three stripes and a second contact connecting the second extremities of the three stripes.

## Claims

1. A precision resistor formed on a semiconductor substrate (8), comprising two stripes made of a resistive conductive material (1, 2) disposed on an insulating material (4), each stripe having a first resistance per square $R_p$ and a normal width $W_p$, defining between them, in said semiconductor substrate, a stripe (6) having a normal width $W_m$, doped by using the stripes of the resistive conductive material as a mask and having a second resistance per square $R_m$, two metallizations (10, 12) connecting said first and second extremity, respectively, of said three stripes, the widths and resistances per square being chosen so that $R_p W_p = 2R_m W_m$.

2. A precision resistor according to claim 1, characterized in that said resistive conductive material is made of doped polycrystalline silicon.

3. A precision resistor according to claim 1, characterized in that said resistor is delineated by thick oxide regions (4) surrounding a region in which said doped stripe extends, each of said stripes made of resistive conductive material partially extending over a thick oxide layer and partially over a thin oxide layer prolonging each thick oxide stripe on the side of the other thick oxide stripe.

4. A precision resistor according to claim 1, characterized in that the assembly of said doped stripe and said stripes made of resistive conductive material is coated with an insulating layer and wherein said metallizations contact the extremities of said stripes through apertures.

5. A method for manufacturing a precision resistor according to any of claims 1 to 4, characterized in that it comprises the following steps:

    forming thick oxide regions delineating between them a semiconductor substrate stripe coated with a thin oxide layer;
    coating the structure with a polycrystalline silicon layer;
    etching two stripes (1, 2) in the polycrystalline silicon layer, each extending along said semi-

Fig. 1

Fig. 2A

Fig. 2B